# EUROPEAN PATENT APPLICATION

(11) **EP 2 492 240 A1**
(43) Date of publication of application: **29.08.2012**
(21) Application number: 11155694.0
(22) Date of filing: 23.02.2011
(51) Int. Cl.: B81C 1/00

(54) **IC with pressure sensor and manufacturing method thereof**

(71) Applicant: NXP B.V., 5656 AG Eindhoven (NL)
(72) Inventor: Merz, Matthias, Redhill, Surrey RH1 1DL (GB); Ponomarev, Youri Victorovitch, Redhill, Surrey RH1 1DL (GB)
(74) Representative: Hardingham, Christopher Mark

(57) **Abstract**

Disclosed is an integrated circuit (IC) comprising a body (10) including a plurality of circuit elements; and a metallization stack over said circuit elements for interconnecting said circuit elements, wherein the metallization stack comprises a conductive layer portion (22) opposite a flexible further conductive layer portion (24) and separated therefrom by a fluid medium (26), a surface of the said flexible further conductive layer portion being exposed to an external pressure; wherein at least some of the circuit elements are arranged to determining the external pressure by measuring a capacitance across the conductive layer portion and the flexible further conductive layer portion. A method of manufacturing such an IC is also disclosed.

## Description

### FIELD OF THE INVENTION

The present invention relates to an integrated circuit (IC) comprising a pressure sensor.

The present invention further relates to a method of manufacturing such an IC.

### BACKGROUND OF THE INVENTION

Many integrated circuits (ICs) nowadays are multi-functional devices such that when integrated in their intended destination application they can provide a wide range of functions. Such intended destination may range from handheld communication devices such as mobile phones where the IC multifunctionality for example can improve the user experience to automotive applications where the various IC functions for example may be utilized to increase the safety of the vehicle.

One particular type of functionality that has been added to ICs is sensing. ICs may contain different types of sensors such as a temperature sensor to provide a user with meteorological information, a humidity or liquid immersion sensor to detect the exposure of the application comprising the IC to (excessive) moisture, which can be used for the verification of warranty entitlement in case of field returns, image sensors for providing camera functionality and so on.

It is also possible to include a pressure sensor in an IC design. Such a pressure sensor may for instance be used as a barometer in a device providing weather information, as a tire pressure sensor in a vehicle and so on. An example of an IC extended with a pressure sensor is for instance disclosed in US 2010/0171153 A1, which discloses a MEMS pressure sensor that can be manufactured using standard foundry processes, in particular CMOS. The latter is important in order to allow the extension of the IC functionality with sensors without significantly adding to the manufacturing cost of the IC.

However, although the MEMS sensor of US 2010/0171153 A1 can be manufactured in a CMOS process, it still requires the inclusion of a significant number of additional process steps to allow for the inclusion of the sensor in the IC design. This can still prohibit the inclusion of the pressure sensor in the design, especially in large volume application domains where profit margins are small, as the added cost of additional process steps to realize the sensor functionality may not be economically feasible.

### SUMMARY OF THE INVENTION

The present invention seeks to provide an IC with an integrated pressure sensor that can be realized in a more cost-effective manner.

The present invention further seeks to provide a method of manufacturing such an IC.

According to an aspect of the present invention, there is provided an IC comprising a body and a metallization stack over said body, wherein the metallization stack comprises a conductive layer portion opposite a flexible further conductive layer portion and separated therefrom by a cavity, a surface of the said flexible conductive layer portion being exposed to an external pressure.

By realizing the pressure sensor in the back end of the IC manufacturing process, very few additional processing steps are required such that the pressure sensor functionality can be added to the IC at limited additional cost, such that the cost for handling and packaging can be reduced, thus resulting in a much more price competitive product. Also, the footprint of the IC and pressure sensor on a PCB is considerably reduced when going from two separate to a single integrated component. This is particularly important for small handheld devices or watches. Moreover, the reduction in electrical connections such as bondwires achieved by the integration of the pressure sensor in the metallization stack increases device reliability which is important for safety critical applications such as tire pressure monitoring or medical systems.

The cavity between the conductive layer portion and the flexible further conductive layer portion may be filled with any suitable fluid medium. Preferably, the cavity comprises a vacuum as the absence of a (substantial) gas pressure in the cavity ensures that the pressure sensor remains largely insensitive to temperature variations. Such a vacuum can be achieved without additional processing steps as sealing layers are usually deposited under vacuum anyway.

In an embodiment, the body includes a plurality of circuit elements; the metallization stack is arranged to interconnect said circuit elements; and at least some of the circuit elements are arranged to determining the external pressure by measuring a capacitance across the conductive layer portion and the flexible further conductive layer portion such that the pressure sensor data can be processed in the same chip.

The metallization stack typically comprises plurality of patterned electrically conductive layers spatially separated from each other by electrically insulating layers, in which layer portions of separate conductive layers may be conductively connected to each other through conductive vias that extend through electrically insulating layers separating such layer portions. The present invention is not limited to any particular type of IC metallization; for instance, at least some of the electrically conductive layers may comprise a stack of conductive sublayers, as is common in modern process technologies, e.g. CMOS process technologies.

In an embodiment, the flexible further conductive layer portion comprises a plurality of sealed openings. The presence of openings are indicative of the IC having been manufactured in accordance with a preferred embodiment of the method of the present invention, as will be explained in more detail below.

The holes are preferably sealed by a flexible sealing layer covering at least a part of said surface of the flexible further conductive layer portion. In an embodiment, the sealing layer may be a thin metal layer such as an Al or Cu layer, which has the advantage that the Al layer can be used for multiple purposes. For instance, in case of the presence of bond pads on the exposed surface of the metallization stack, the Al layer can act as a contact area on top of the bond pad to improve the reliability of the contact to be formed thereon.

Alternatively, the sealing layer may be a dielectric layer, such as silicon nitride. Such dielectric layers may be deposited using vacuum deposition methods, which have the advantage that a vacuum in the cavity may be obtained without additional processing steps. Also, as such dielectric materials have different mechanical properties than the metal portions used to define the pressure sensor, such materials can be used to alter (tune) the pressure response characteristics of the membrane of the pressure sensor formed by the flexible further conductive layer portion and the covering dielectric material portion.

The conductive layer portion and the flexible further conductive layer portion typically form part of a hermetically sealed chamber, said surface of the flexible further conductive layer portion defining an outer wall of said chamber, such that a change in pressure exerted on the exposed side of the flexible further conductive layer portion leads to a deformation of this portion, which can be measured as a change in the capacitance defined by the conductive layer portion and the flexible further conductive layer portion defining the capacitor plates and the fluid-filled gap defining the dielectric between the plates.

In an advantageous embodiment, the metallization stack comprises a support structure carrying the flexible further conductive layer portion. Such a support structure, which typically comprises a plurality of patterned metal portions separated by respective dielectric layers, and which may extend from the substrate of the sensor to the further flexible conductive layer portion, improves the reliability of the pressure sensor as the pressure variation-induced behavior of the flexible further conductive layer portion becomes largely independent of the size of the gap formed between the conductive layer portion and the flexible further conductive layer portion. The support structure further improves the mechanical stability of the pressure sensor.

The integrated circuit may further comprise an output conductively coupled to the at least some of the circuit elements arranged to provide an output signal indicative of the measured external pressure. Such an output signal may for instance be a control signal for generating a warning signal that the determined external pressure lies outside a tolerance window, as for instance would be useful for monitoring tire pressures. Alternatively, the output signal can be used for driving a display such that the measured pressure value can be displayed to a user. This is for instance useful when the pressures sensor is used as a barometer in a portable device such as a wrist watch or a mobile communications device, e.g. a mobile phone or personal digital assistant.

The IC of the present invention may be integrated in any suitable apparatus, such as a portable device as mentioned above, a vehicle such as a motor bike, automobile, and so on.

In accordance with another aspect of the present invention, there is provided a method of providing a pressure sensor in an integrated circuit, comprising providing a semiconductor body comprising a plurality of circuit elements; interconnecting the plurality of circuit elements by forming a metallization stack over said body, wherein the step of forming said metallization stack further comprises forming a first patterned conductive layer including a first conductive portion; covering said first patterned conductive layer with an electrically insulating layer; forming a second patterned conductive layer including a further flexible conductive portion opposite said first conductive portion such that said further flexible conductive portion is exposed to an external pressure; removing at least a part of the electrically insulating layer from in between said conductive portions to form a chamber including a cavity between the first conductive portion and the further flexible conductive portion; and hermetically sealing the chamber.

This has the advantage that an IC extended with pressure sensor functionality can be manufactured with minimal adjustments to a manufacturing process flow, as only one additional mask is required for the formation of the gap between the first conductive portion and the further flexible conductive portion. The formation of the first conductive portion and the further flexible conductive portion can be realized by the incorporation of the pressure sensor design in the mask set used for the formation of the corresponding conductive layers of the metallization stack.

Preferably, the method further comprises providing a plurality of openings in the further flexible conductive portion, wherein the step of removing at least a part of the electrically insulating layer from in between said conductive portions comprises at least partially removing said electrically insulating layer through said openings, and wherein the step of hermetically sealing the chamber comprises sealing said openings. This improves the control over the dimensions of the gap between the first conductive portion and the further flexible conductive portion formed during the removal of the electrically insulating layer in between these portions, which improves the reliability of the pressure sensor as variations in the gap dimensions can lead to unpredictable responsiveness to pressure variations and lifetime issues. The openings (holes) provide etchant access to the underlying dielectric materials, with the opening density being inversely correlated to the etch time and underetch of laterally displaced structures in the metallization stack; a high density of such openings hence allows for a relatively short etching time, thus reducing the unwanted underetch of these laterally displaced structures in the metallization stack.

In an advantageous embodiment, the step of hermetically sealing the chamber comprises depositing a metal coating over the exposed surface of the integrated circuit, e.g. an Al or Cu coating. Alternatively, the step of hermetically sealing the chamber comprises depositing a polymer coating over the exposed surface of the integrated circuit. The polymer preferably has a high enough viscosity to prevent the polymer from penetrating the gap between the first conductive portion and the further flexible conductive portion through the openings in the further flexible conductive portion.

In a further alternative embodiment, the step of hermetically sealing the chamber comprises depositing a thin dielectric layer over the exposed surface of the integrated circuit. This for instance has the advantage that a vacuum may be established in the cavity without requiring additional processing steps, and allows for a tuning of the pressure response properties of the pressure sensor as previously explained.

In order to further improve the accuracy of the responsiveness of the further flexible conductive layer portion to pressure variations, the step of forming a metallization stack over said body may further comprise forming a support structure delimiting the first patterned conductive layer portion, wherein the further flexible conductive portion is supported by said support structure.

### BRIEF DESCRIPTION OF THE EMBODIMENTS

Embodiments of the invention are described in more detail and by way of non-limiting examples with reference to the accompanying drawings, wherein
FIG. 1A-E schematically depict various stages of a method of manufacturing an IC including a pressure sensor in accordance with an embodiment of the present invention;
FIG. 2 schematically depicts an IC a pressure sensor in accordance with an alternative embodiment of the present invention; and
FIG. 3 schematically depicts an IC a pressure sensor in accordance with an alternative embodiment of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

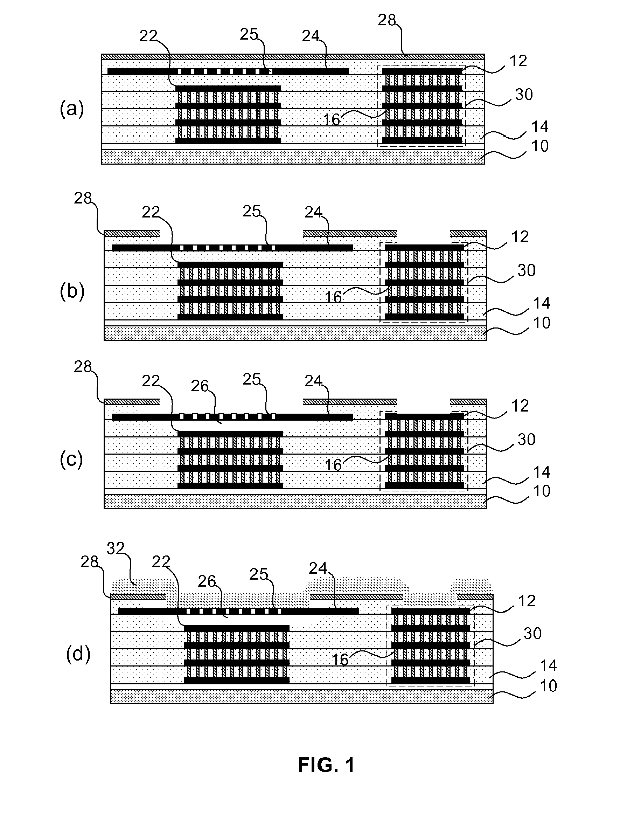

FIG. 1a depicts the starting point of an embodiment of the method of the present invention for integrating a pressure sensor into an IC in the backend manufacturing process, more particularly by inclusion of the pressure sensor in the metallization stack of the IC. The intermediate structure shown in FIG. 1A typically comprises a semiconductor body including a substrate 10, onto which a stack of patterned metal layers 12 separated by dielectric layers 14 is provided. The substrate 10 typically comprises a plurality of circuit elements (not shown), e.g. transistors, diodes, and so on that have been formed on the substrate 10 in any suitable manner. The substrate 10 may be formed on any suitable material, e.g. silicon, silicon on insulator, silicon/germanium and so on.

The metallization stack may also be formed in any suitable manner, such as for instance by means of a CMOS compatible manufacturing process of an electronic device. In Fig. 1a, an IC having five metal layers is shown by way of non-limiting example only. The device may have any suitable number of metal layers. The dielectric layers 14 in between the metal layers 12 comprise vias 16 for conductively connecting vertically displaced metal layer portions. Such via-comprising dielectric layers 14 will also be referred to as via layers. Further via layers, e.g. between the bottom metal layer 12 and the substrate 10 may also be provided.

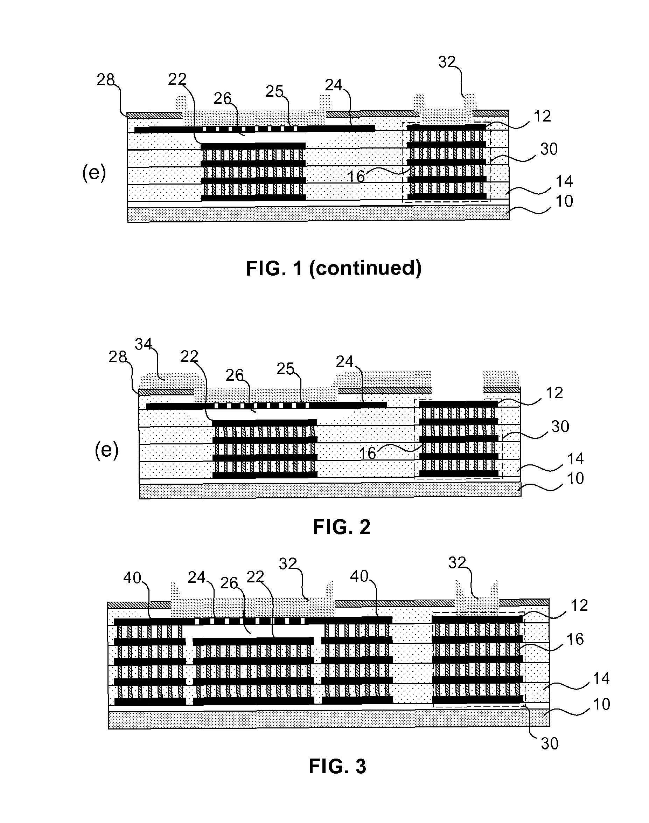

Each metal layer 12 and each dielectric layer 14 is depicted as a single layer in Fig. 1 for the sake of clarity only. It should be appreciated that such layers may consist of a number of stacked sub-layers, for instance in a submicron CMOS process, stacks of Ti, TiN, AlCu, TiN may be used to define a single metal layer in the metallization stack. Similarly, it will be apparent that the vias 16 may be formed from more than a single material. For instance, in the aforementioned CMOS 14 technology, a via 16 may be formed by a TiN liner and a W plug. Other semiconductor processes may use different materials, e.g. Cu for the metal layers 12 and vias 16.

Each of the dielectric layers 14 may also comprise more than a single layer. For instance, such a dielectric layer may be a stack comprising FSG (fluorosilicate glass), SiO₂ and HDP oxide (High Density Plasma) any other suitable dielectric material combination. Other suitable materials may also be used. In Fig. 1a, a cross-section of a partially processed semiconductor device structure is shown in which the deposition of the metallization stack has been completed. This has not been explained in further detail for reasons of brevity because this structure may be obtained using existing processing steps. The metallization stack typically comprises a plurality of interconnect structures for interconnecting circuit elements, e.g. transistor terminals, in the substrate 10 or for connecting such circuit elements to external contacts, e.g. bond pads or pins, of the semiconductor device, e.g. IC. The metallization stack will typically be protected by a passivation layer or layer stack 28, which may for instance comprise one or more oxide and nitride layers. The passivation layer 28 typically protects the underlying structures from scratching and so on.

In FIG. 1a, the metallization stack comprises a first conductive portion 22 (shown in Metal layer 4 by way of non-limiting example) and a further conductive portion 24 (shown in Metal layer 5 by way of non-limiting example) that is oriented opposite the first conductive portion 22. The second conductive portion 24 is typically oriented in an upper metallization layer such that upon opening the layer stack, the upper surface of the second conductive portion 24 is exposed to the environment of the IC. Both the first conductive portion 22 and the second conductive portion 24 are connected to circuit elements on the substrate 10. These connections have not been shown for the sake of clarity only. The first conductive portion 22 and the second conductive portion 24 form the opposite plates of a capacitive pressure sensor to be formed in the metallization stack, as will be explained in more detail below.

In the next step of the embodiment of the present invention depicted in FIG. 1b, the passivation layer 28 is opened to expose the bond pad 30 and the second conductive portion 24. This may be achieved using any suitable combination of etch recipes. It is noted that a chip die commonly is shipped from the foundry in this form (i.e. with the passivation stack 28 patterned to expose areas for further processing such as external contact forming at a different location). As such a passivation stack 28 opening process is well-known per se, it will not be explained in further detail for the sake of brevity.

The method proceeds as shown in FIG. 1c, in which the electrically insulating material 14 in between the first conductive portion 22 and the second conductive portion 24 is selectively removed. This may be achieved by an anisotropic etch such as a HF vapor etch or a suitable wet etch recipe. Other etching recipes, e.g. a dry etch, are equally feasible. Prior to the selective etch, the other exposed regions of the metallization stack, e.g. the exposed region over the bond pad 30, may be protected from being exposed to the etch recipe by a suitable resist. As the formation of etch resists is well-known per se, this is not shown for the sake of brevity.

It is for instance possible to deposit the resist followed by a resist patterning step to expose only those areas to be etched away, and subsequently perform the anisotropic etch of the electrically insulating material 14 in between the first conductive portion 22 and the second conductive portion 24. To this end, a positive resist may be deposited over the patterned passivation layer 28 and developed using this mask such that the resist material over the second conductive portion 24 can be selectively removed.

In case of aggressive etchants such as HF vapor, the resist may be replaced by a suitable hard mask such as Al₂O₃, SiC or metallic hard masks. The hard mask may be patterned to expose the regions to be exposed to the etch recipe in any suitable manner, e.g. by resist deposition, patterning, subsequent hard mask patterning (etch) and resist strip. The patterned hard mask may be removed after completion of the etch step. This removal may be necessary in case of a metallic hard mask to prevent short circuits with the hard mask occurring in subsequent processing steps.

However, it should be understood that alternative solutions are equally feasible. It is for instance equally feasible to selectively open the passivation layer 28 over the second conductive portion 24 to expose the second conductive portion 24 and use the passivation layer 28 as a hard mask for the selective removal of the electrically insulating material 14 in between the first conductive portion 22 and the second conductive portion 24, after which the remainder of the passivation layer 28 may be selectively opened to expose contact areas such as bond pad 30 after having sealed the area of the passivation layer 28 over the second conductive portion 24, as will be explained in more detail later.

The anisotropic etch of the electrically insulating material 14 in between the first conductive portion 22 and the second conductive portion 24 forms a cavity or gap 26 in between the first conductive portion 22 and the second conductive portion 24 as shown in FIG. 1c. The dimensions of the gap 26 are determined by the height of the vias 16 in the dielectric layer 14 separating the first conductive portion 22 and the second conductive portion 24, and the presence of the gap or cavity 26 causes the second conductive portion 24 to become deformable as a function of the external (atmospheric) pressure exerted on the second conductive portion 24. In other words, the second conductive portion 24 acts as a pressure-sensitive membrane. It is noted that the thickness of the metal layers in a metallization stack as routinely implemented in a standard manufacturing process such as a CMOS process are sufficiently thin to result in the second conductive portion 24 becoming flexible upon the creation of the cavity 26 such that no process alterations are required to achieve the desired flexibility of the second conductive portion 24.

It will be appreciated that as long as the gap 26 is not in communication with the environment of the IC (i.e. is sealed), changes in the external pressure cause a deformation of the second conductive portion 24, which causes a change in the overall capacitance of the capacitor defined by the first conductive portion 22 and the second conductive portion 24, i.e. the plates of the capacitor, and the gap 26 in between the first conductive portion 22 and the second conductive portion 24, i.e. the dielectric medium separating the plates.

This change in capacitance can be determined by the circuit elements (not shown) to which the first conductive portion 22 and the second conductive portion 24 are conductively coupled through the metallization stack, and can be translated into a pressure measurement, e.g. by comparison of the measured capacitance with a reference pressure value as for instance may be stored in a memory such as a look-up table.

The second conductive portion 24 may comprise a plurality of holes or perforations 25 to facilitate access to the electrically insulating material 14 in between the first conductive portion 22 and the second conductive portion 24, such that the anisotropic etch step can be completed more easily and more quickly. This has the advantage that the dimensions of the gap 26 can be better controlled, which improves the accuracy of the capacitive pressure sensor. The holes 25 may be formed by the modification of the mask for patterning the corresponding metal layer in the formation of the metallization stack. In other words, such holes 25 may be provided without requiring additional processing steps.

As has been mentioned above, in order for the pressure sensor to respond correctly to changes in ambient pressure, the gap 26 must not be in direct fluidic communication with the environment of the IC. To this end, the pressure sensor is hermetically sealed as shown in FIG. 1d by the deposition of a sealing layer 32 over the resultant structure. In the embodiment shown in FIG. 1d, the sealing layer 32 is of a conductive material such as Al, which has the advantage that the sealing layer can also be on the contact areas of the metallization layer such as the bond pad 30. The sealing layer 32 may be deposited in any suitable manner, e.g. through sputtering.

Care has to be taken that the conductive sealing layer 32 does not excessively penetrate the pressure sensor through the holes 25 of the second conductive portion 24 as this can lead to the formation of conductive interconnections between the first conductive portion 22 and the second conductive portion 24, thus shorting these capacitor plates. This can be avoided by dimensioning the holes 25 such that they are readily sealed by the deposition of the conductive sealing layer 32, in particular when the conductive sealing layer 32 is deposited anisotropically. Preferably, the holes 25 are given the smallest dimensions that are allowed in the design rules of the manufacturing process, as this minimizes the risk of the unwanted deposition of sealing material in the cavity 26. For instance, in a 140 nm CMOS technology, the dimensions of the holes 25 may be in the 250-500 nm range. These values will be smaller in more advanced technologies.

The sealing layer 32 may be deposited under selected atmospheric conditions, preferably vacuum, to set a particular pressure in the pressure sensor,. Vacuum pressure is preferred as this often means that no special processing conditions are required for the deposition of the sealing layer 32, thus making it a cost-effective solution. This further has the advantage that the internal pressure of the pressure sensor becomes largely independent of temperature.

The sealing layer 32 subsequently is patterned as shown in FIG. 1e to limit the presence of the sealant to intended areas. This may be done in any suitable manner. Such a patterning process is known per se and is not further explained for reasons of brevity only. In case of a conductive sealing layer 32, the sealing layer is removed from surfaces not intended to be electrically conductive to avoid short contacts between electrically conductive surfaces.

The thickness of the sealing layer 32 is such that the combination of the conductive sealing layer 32 and the second conductive portion 24 remain flexible, i.e. deformable such that a change in ambient pressure in the environment of the IC causes a change in the capacitance of the capacitor defined by the first conductive portion 22 and the second conductive portion 24 and the gap 26 in between as previously explained. At this point it is reiterated that in typical metallization stack formation processes the thickness of the second conductive portion 24 is such that such flexibility is inherently present in these layers; i.e. no process alterations are required to introduce the necessary flexibility to facilitate the pressure-induced deformation of these layers.

The material used for the sealing layer 32 does not have to be a conductive material. An alternative embodiment of a sealing layer 34 is shown in FIG. 2, in which the sealing layer is a non-conductive sealant, such as a high-viscosity polymer or a dielectric material such as silicon nitride or SiO₂; other dielectric materials are also feasible. In the context of the present invention, high-viscosity is intended to mean a viscosity high enough to prevent excessive penetration of the holes 25 in the second conductive portion 24 by the polymer.

In this embodiment, the sealing layer 34 is removed from the contact surface of the bond pad 30 to allow the bond pad 30 to be conductively bonded to an external contact. The polymer sealing layer 34 may be deposited in any suitable manner, e.g. by spinning it onto the IC surface. Again, the sealing layer 34 is deposited such that it hermetically seals the pressure sensor and has a thickness ensures that the combination of the sealing layer 34 and the second conductive portion 24 remains deformable under ambient pressure exerted thereon.

A further embodiment of the IC of the present invention is shown in FIG. 3. In this embodiment, the metallization stack comprises a support structure 40 surrounding the first conductive portion 22, with the second conductive portion 24 being supported by the support structure 40. The support structure, which typically extends from the substrate 10 to the second conductive portion 24, can be formed in the same manner as the bond pad 30 such that the inclusion of such a support structure does not require additional processing steps, but can be included in the design of a standard process.

The advantage of the presence of the support structure 40 is that the behavior of the pressure sensor becomes less dependent on the dimensions of the gap 26. More particularly, as it is difficult to control the dimensions of the gap 26 in anisotropic etching processes, the area of the free membrane (i.e. the deformable area of the second conductive portion 24) may become poorly defined which can result in unpredictable sensor characteristics and lifetime issues due to a reduced stability of the second conductive portion 24. The support structure 40 significantly improves the stability of the second conductive portion 24 as well as the definition of its deformable area. This is particularly relevant for relatively large gaps 26. For smaller gaps 26, process variations are less-pronounced such that the support structure 40 may be omitted.

At this point it is noted that preferably the electrode 22 is also supported by a support structure as shown in FIG. 1-3. This prevents the electrode 22 from becoming unstable in case of an overetch of the cavity 26. Such a support structure may for instance be formed by a stack of metal layers 12 in the metallization stack as shown in FIG. 1-3, with the metal layers separated by the dielectric layers 14. Such a support structure may extend from the substrate 10 upwards although this is not essential.

The operation of the pressure sensor is straightforward. The capacitor electrodes formed by the first conductive portion 22 and the second conductive portion 24 respectively are connected to a circuit that measures the capacitance of the capacitor formed by the two electrodes. This circuit preferably is located on-chip. If the ambient pressure decreases the membrane (the second conductive portion 24) moves away from the bottom electrode (first conductive portion 22); d increases resulting in a capacitance decrease according to *c=εε₀A*/*d.* An ambient pressure increase brings both electrodes closer together, d decreases and *c* increases.

An on-chip calibration circuit may calculate the actual pressure from the measured capacitance values. The sensor can be calibrated during die testing in the fab or after packaging, e.g. using ambient pressure for a single point calibration or a range of pressures in a pressure chamber for a multi-point calibration. The calibration data is stored in an on-chip memory. The sensitivity of the sensor is governed by the membrane area A, the space d between the electrodes and the mechanical properties of the materials forming the membrane (the second conductive portion 24 and the sealing layer 32 or 34), such as layer thickness and stress.

It is noted that tensile stress is preferred over compressive stress for the operating principle of the pressure sensor. Since the mechanical characteristics of the metal layer from which the deformable membrane is formed is preferably determined by standard process, the mechanical properties of the membrane may be tuned by adjustment of the thickness and/or material choice of the additional sealing layer 32 over the deformable conductive portion 24.

The IC may further comprise an output for providing an output signal indicative of the measured pressure. The output signal may provide the actually measured pressure or may be a comparison result indicating that the measured pressure lies outside an acceptable range, e.g. a warning signal indicating a too high or too low pressure.

The IC may be integrated in any apparatus requiring pressure-measuring functionality, e.g. a tire pressure monitor for a vehicle or a consumer electronics device for providing meteorological data, i.e. barometric pressure. Such an electronics device may for instance be a mobile phone, a PDA, a wrist watch and so on.

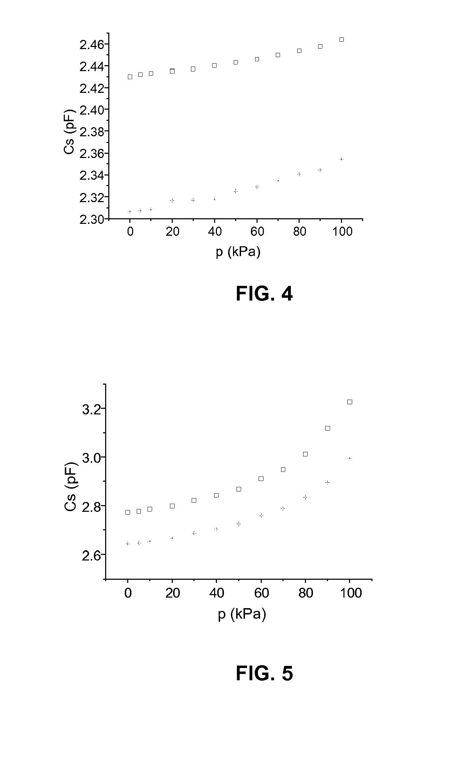

FIG. 4 and FIG. 5 depicts the response curves of a pressure sensor having a 100x100 µm membrane (FIG. 4) and a 200x200 µm membrane (FIG. 5) respectively. The respective membranes are formed of a Al metallization layer portion of a thickness of around 450nm as the deformable conductive portion 24 covered by a 1 µm thick CVD deposited SiO₂ layer as the sealing layer 32. The pressure sensor has been formed in a standard CMOS IC manufacturing process. The different curves in each figure represent the test results for different ICs from the manufacturing batch. The difference in the response curves can be explained by process variations in the manufacturing process. Such variations are not problematic as the sensor can simply be calibrated prior to use.

It is clearly demonstrated in FIG. 4 and 5 that a pressure sensor can be successfully integrated in a standard manufacturing process in accordance with the present invention.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. An integrated circuit comprising:
a body (10); and
a metallization stack over said body, wherein the metallization stack comprises a conductive layer portion (22) opposite a flexible further conductive layer portion (24) and separated therefrom by a cavity (26), a surface of the said flexible further conductive layer portion being exposed to an external pressure.

2. The integrated circuit of claim 1, wherein:.
the body (10) includes a plurality of circuit elements;
the metallization stack is arranged to interconnect said circuit elements;
and
at least some of the circuit elements are arranged to determining the external pressure by measuring a capacitance across the conductive layer portion and the flexible further conductive layer portion.

3. The integrated circuit of claim 1 or 2, wherein the metallization stack comprises plurality of patterned electrically conductive layers (12) spatially separated from each other by electrically insulating layers (14).

4. The integrated circuit of any of claim 3, wherein at least some of the electrically conductive layers (12) comprises a stack of conductive sublayers.

5. The integrated circuit of any of claims 1-4, wherein the flexible further conductive layer portion (24) comprises a plurality of sealed openings (25).

6. The integrated circuit of claim 5, wherein said openings (25) are sealed by a flexible sealing layer (32, 34) covering at least a part of said surface of the flexible further conductive layer portion (24).

7. The integrated circuit of any of claims 1-6, wherein the conductive layer portion (22), the flexible further conductive layer portion (24) and the cavity (26) form part of a hermetically sealed chamber, said surface of the flexible further conductive layer portion defining an outer wall of said chamber.

8. The integrated circuit of any of claims 1-7, wherein the metallization stack comprises a support structure (40) for supporting said flexible further conductive layer portion (24).

9. The integrated circuit of any of claims 1-8, further comprising an output conductively coupled to the at least some of the circuit elements arranged to provide an output signal indicative of the measured external pressure.

10. An apparatus comprising the integrated circuit of any of claims 1-9.

11. A method of providing a pressure sensor in an integrated circuit, comprising:
providing a semiconductor body (10) comprising a plurality of circuit elements;
interconnecting the plurality of circuit elements by forming a metallization stack over said body, wherein the step of forming said metallization stack further comprises:
forming a first patterned conductive layer (12) including a first conductive portion (22);
covering said first patterned conductive layer with an electrically insulating layer (14);
forming a second patterned conductive layer (12) including a further flexible conductive portion (24) opposite said first conductive portion such that said further flexible conductive portion is exposed to an external pressure;
removing at least a part of the electrically insulating layer from in between said conductive portions to form a chamber; and
hermetically sealing the chamber.

12. The method of claim 11, further comprising providing a plurality of openings (25) in the further flexible conductive portion (24), wherein the step of removing at least a part of the electrically insulating layer (14) from in between said conductive portions (22; 24) comprises at least partially removing said electrically insulating layer through said openings, and wherein the step of hermetically sealing the chamber comprises sealing said openings.

13. The method of claim 11 or 12, wherein the step of hermetically sealing the chamber comprises depositing a metal coating (32) over the exposed surface of the integrated circuit.

14. The method of claim 11 or 12, wherein the step of hermetically sealing the chamber comprises depositing a dielectric layer over the exposed surface of the integrated circuit.

15. The method of any of claims 11-14, wherein the step of forming a metallization stack over said body further comprises:
forming a support structure surrounding the first patterned conductive layer portion (22), wherein the flexible further conductive portion (24) is supported by said support structure.
